# FASCICULE DE BREVET EUROPEEN

(11) **EP 1 481 112 B1**
(45) Date de publication et mention de la délivrance du brevet: **26.07.2006**
(21) Numéro de dépôt: 03720624.0
(22) Date de dépôt: 19.02.2003
(51) Int. Cl.: C23G 5/00

(54) **PROCEDE DE NETTOYAGE PAR PLASMA DE LA SURFACE D'UN MATERIAU ENDUIT D'UNE SUBSTANCE ORGANIQUE, ET INSTALLATION DE MISE EN OEUVRE**
VERFAHREN ZUM PLASMAREINIGEN VON MIT EINER ORGANISCHEN SUBSTANZ BESCHICHTETEN MATERIALOBERFLÄCHEN UND VORRICHTUNG DAFÜR
METHOD FOR THE PLASMA CLEANING OF THE SURFACE OF A MATERIAL COATED WITH AN ORGANIC SUBSTANCE AND THE INSTALLATION FOR CARRYING OUT SAID METHOD

(30) Priorité: 19.02.2002 FR 0202057
(43) Date de publication de la demande: 01.12.2004
(73) Titulaire: ARCELOR France, 93212 La Plaine Saint Denis Cedex (FR)
(72) Inventeur: SILBERBERG, Eric, B-5340 Haltinne (Gesves) (BE); MICHEL, Eric, F-57270 Uckange (FR); RENIERS, François, B-1170 Watermael-Boitsfort (BE); BUESS-HERMAN, Claudine, B-3090 Overijse (BE)
(74) Mandataire: Plaisant, Sophie Marie
(86) Numéro de dépôt international: PCT/FR2003/000542
(87) Numéro de publication internationale: WO 2003/071004

(56) Documents cités:
- WO-A-02/43781
- DE-A- 4 308 632
- DE-A- 4 332 866
- US-A- 5 529 631
- US-A- 5 938 854
- US-A- 5 968 377
- KORZEC D ET AL: "CLEANING OF METAL PARTS IN OXYGEN RADIO FREQUENCY PLASMA: PROCESS STUDY" JOURNAL OF VACUUM SCIENCE AND TECHNOLOGY: PART A, AMERICAN INSTITUTE OF PHYSICS. NEW YORK, US, vol. 12, no. 2, 1 mars 1994 (1994-03-01), pages 369-378, XP000442717 ISSN: 0734-2101

## Description

La présente invention concerne un procédé de nettoyage par plasma à une pression comprise entre 10 mbar et 1 bar, de la surface d'un matériau enduit d'une substance organique, ainsi qu'une installation de mise en oeuvre de ce procédé, plus particulièrement destinée au nettoyage de tôles métalliques.

Dans le cadre de la présente demande, on entend par substance organique, tout composé insoluble dans l'eau comprenant du carbone, de l'oxygène et de l'hydrogène.

Les tôles issues des différentes filières de fabrication sont généralement recouvertes d'un film d'huile qui peut avoir deux origines. Tout d'abord, ce film peut avoir été appliqué à partir d'un spray d'huile de protection, afin de protéger la surface de la tôle contre la corrosion. Mais il peut également s'agir d'un film résiduel d'huile dans le cas des tôles provenant du laminoir à froid ou du skin-pass. Dans les deux cas, les grammages en huile peuvent atteindre plusieurs centaines de mg par m².

La réalisation d'un dépôt métallique ou organique sur ces tôles nécessite l'élimination du film d'huile lors d'une opération de dégraissage, pour obtenir une bonne adhérence de ce revêtement. Les techniques généralement utilisées dans ce but sur les lignes industrielles ne doivent pas échauffer la tôle outre mesure, afin de conserver les propriétés mécaniques de la bande d'acier.

Ainsi, la plus courante de ces techniques consiste en un dégraissage alcalin assisté ou non par un procédé électrolytique. Pour des raisons environnementales, ce procédé nécessite l'installation d'ateliers annexes complexes pour le retraitement des co-produits éco-toxiques.

D'autres solutions techniques permettent d'éviter la formation de ces co-produits, comme par exemple, l'ablation laser qui a pour effet de désorber les composés organiques par voie photochimique, mais ne permet pas de traiter des bandes à des vitesses dépassant 10 m/min par manque de puissance.

Il a été récemment découvert qu'une technique avantageuse de nettoyage consistait à utiliser un plasma à pression proche de la pression atmosphérique, réalisé grâce à des décharges à barrière diélectrique dans des mélanges gazeux contenant de l'oxygène. Il se produit alors une réaction entre les espèces réactives de l'oxygène (O°, etc...) formées et les composés organiques de l'huile, avec production de dioxyde de carbone et d'eau.

La décharge à barrière diélectrique présente notamment l'avantage de générer un plasma froid, ne dégradant pas les caractéristiques de la tôle.

Mais, l'obtention d'une décharge stable et homogène à des pressions proches de la pression atmosphérique nécessite généralement d'avoir un mélange constitué très majoritairement d'hélium. La proportion d'oxygène dans le mélange est donc faible, et on constate que le traitement n'est pas suffisamment rapide, probablement en raison de la faible densité d'espèces oxygénées réactives, mais aussi d'une polymérisation intempestive de la substance organique à éliminer.

Ainsi, le brevet US 5 529 631 décrit le traitement de matières plastiques au défilé par plasma froid à pression atmosphérique. Les décharges sont stabilisées dans des mélanges gazeux à base d'hélium, avec éventuellement jusqu'à 25% en volume d'un autre gaz. La technique requiert un contrôle strict de l'atmosphère de l'enceinte à plasma par la mise en place de sas en entrée et en sortie de cuve. L'utilisation de l'hélium comme gaz plasmagène et la complexité de l'équipement rendent ce procédé aussi onéreux et difficile à mettre en oeuvre qu'un procédé classique sous vide. En outre, il ne permet pas de dégraisser des bandes défilant à une vitesse supérieure à 3 m/min.

Par ailleurs, le brevet US 5 938 854 décrit un procédé de nettoyage de surfaces plastiques et métalliques par une décharge luminescente homogène initiée dans l'air à des pressions comprises entre 0,0133 bar (10 torr) et 20 bar. En plus d'un équipement complexe, le travail à ces pressions en air nécessite d'augmenter considérablement la tension d'amorçage de la décharge, qui est directement liée à la pression.

Le but de la présente invention est donc de mettre à disposition un procédé de nettoyage de la surface d'un matériau enduit d'une substance organique, qui permette d'obtenir un nettoyage homogène de ladite surface à une vitesse de traitement d'au moins 10 m/min, sous des pressions proches de la pression atmosphérique.

A cet effet, un premier objet de l'invention est constitué par un procédé de nettoyage de la surface d'un matériau enduit d'une substance organique, comprenant les étapes consistant à :
- introduire ledit matériau dans une enceinte de traitement à l'intérieur de laquelle règne une pression comprise entre 10 mbar et 1 bar, et qui est alimentée par un flux gazeux comprenant au moins 90% en volume d'oxygène,
- générer un plasma en faisant passer une décharge électrique entre la surface dudit matériau et une électrode recouverte de diélectrique, afin de décomposer ladite substance organique sous l'action des radicaux libres O° ainsi produits.

Les présents inventeurs ont constaté que ce procédé permet d'obtenir un traitement homogène et rapide du substrat, alors que la décharge obtenue dans ce mélange gazeux constitué majoritairement d'oxygène, n'est pas homogène. Le régime de décharge semble se situer entre la décharge filamentaire et l'arc froid. En effet, les espèces actives non chargées O° générées par le plasma se distribuent à la surface de la tôle sous l'action du flux et indépendamment du champ électrique, et décapent uniformément le matériau enduit de substance organique, en raison de leur densité accrue due à la forte proportion d'oxygène présent. Dans un mode de réalisation préféré, on re-dissocie les molécules d'oxygène et/ou d'ozone qui se sont formées par recombinaison des radicaux libres O° produits dans ledit plasma. On peut ainsi augmenter la densité d'espèces actives non chargées qui se distribuent à la surface de la tôle indépendamment du champ électrique, améliorant encore l'homogénéisation du traitement.

Cette re-dissociation peut être effectuée au moyen d'un rayonnement UV de longueur d'onde adaptée, qui permet à l'ozone produit par recombinaison en dehors des arcs froids de se dissocier en oxygène moléculaire et en radical O°.

Dans un autre mode de réalisation préféré, on applique une tension sinusoïdale dont la fréquence est comprise entre 10 et 100 kHz, pour initier la décharge. En effet, ce type de tension entraîne la présence quasi continue d'espèces actives dans l'espace inter électrodes, ce qui permet des rendements cinétiques élevés.

Dans un autre mode de réalisation préféré, la dissipation d'énergie dans la décharge est inférieure à 40 W/cm² et la tension appliquée pour initier la décharge est inférieure à 4 400 V.

Les présents inventeurs ont en effet constaté que les effets inhibiteurs liés à la polymérisation de l'huile sont d'autant plus importants que la tension appliquée est élevée et que le traitement de surface est inhomogène. En effet, l'oxydation et l'élimination de l'huile se font essentiellement au niveau des impacts des décharges sur la tôle, alors que l'huile polymérise en dehors de ces canaux de luminescence plus intense. L'augmentation de la tension aux bornes de la décharge débouche sur un accroissement de l'énergie des électrons qui amorcent d'autant plus facilement la polymérisation de l'huile.

Le procédé selon l'invention peut en outre présenter les caractéristiques suivantes, seules ou en combinaison :
- la tension appliquée pour initier la décharge est sinusoïdale,
- le matériau est sous forme d'une bande en défilement, et les différentes étapes du procédé sont réalisées en continu au moyen d'installations disposées successivement sur le trajet de la bande en défilement,
- on traite une des faces du matériau puis l'autre,
- le matériau à traiter est un matériau métallique, de préférence un acier au carbone,
- le procédé est mis en oeuvre pour dégraisser la surface de matériaux métalliques, préalablement au dépôt d'un revêtement sur cette surface.

Un second objet de l'invention est constitué par une installation comprenant au moins un module comprenant une enceinte de traitement, des moyens permettant de régler la pression à l'intérieur de ladite enceinte à une valeur comprise entre 10 mbar et 1 bar, des moyens de défilement dans ladite enceinte de ladite bande reliés à la masse, une série d'électrodes recouvertes de diélectrique disposées en face de la surface à traiter de ladite bande, ces électrodes étant reliées à un générateur haute tension sinusoïdale, des lampes à émission UV disposées entre lesdites électrodes des moyens d'alimentation en gaz de ladite enceinte, et des moyens d'extraction de ladite enceinte des gaz de décomposition de la substance organique enduisant la bande.

Dans un mode de réalisation préféré, ladite installation comprend une succession d'un nombre pair desdits modules, à l'intérieur desquels ladite bande défile successivement, exposant tour à tour une de ses faces aux électrodes desdits modules.

Dans un autre mode de réalisation préféré, ladite installation comprend en outre des lampes à émission UV disposées entre lesdites électrodes.

L'invention va être illustrée par la description de deux modes de réalisation donnée à titre indicatif, et non limitatif, en référence aux dessins annexés sur lesquels :
- la figure 1 représente une vue schématique d'une installation de traitement selon l'invention,
- la figure 2 représente une vue schématique d'une installation de traitement selon l'invention permettant un traitement successif des deux faces d'un matériau sous forme de bande en défilement,
- les figures 3A et 3B représentent deux images de surfaces de tôles traitées en présence (3B) ou non (3A) d'une irradiation W,
- la figure 4 met en évidence l'augmentation de la densité des radicaux oxygène lors de l'application additionnelle d'un rayonnement UV à 253 nm,
- la figure 5 montre la dépendance de la densité des radicaux oxygène en fonction de l'intensité I du courant appliqué dans la décharge,
- la figure 6 représente l'évolution du grammage en huile de protection présente sur une tôle en fonction de la dose électronique It/S qui lui est appliquée,
- la figure 7 représente le spectre des électrons Auger de la surface d'une tôle dégraissée à l'aide d'une décharge impliquant une dose électronique de 21 mC/cm².

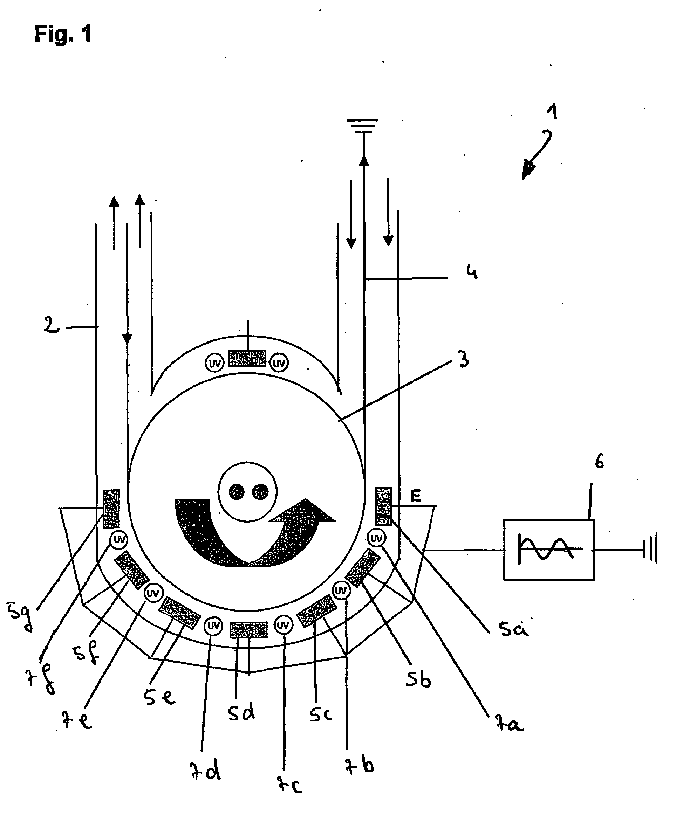

La figure 1 représente le schéma d'une installation selon l'invention permettant de mettre en oeuvre le procédé selon l'invention pour traiter une bande métallique constituée, par exemple d'acier au carbone. Cette installation comprend un module 1 constitué d'une enceinte de traitement 2 à l'intérieur de laquelle se trouve un rouleau refroidi 3 sur lequel la bande métallique 4 vient s'enrouler. Le rouleau 3 et la bande 4 sont à la masse. Des pompes (non représentées) permettant de régler la pression à l'intérieur de cette enceinte 2 à une valeur comprise entre 10 mbar et 1 bar. Des électrodes 5a, 5b, 5c, 5d, 5e, 5f et 5g recouvertes d'un diélectrique (alumine) sont placées en vis-à-vis de la bande 4. Ces électrodes 5a, 5b, 5c, 5d, 5e, 5f et 5g sont reliées à la haute tension alimentée par un générateur sinusoïdal 6 de moyennes fréquences (comprises entre 10 et 100 kHz). Les électrodes haute tension 5a, 5b, 5c, 5d, 5e, 5f et 5g sont également refroidies. De manière à optimiser l'énergie investie dans la décharge, la fixation des électrodes haute tension 5a, 5b, 5c, 5d, 5e, 5f et 5g permet une variation de la distance inter électrodes.

Le module comprend également des moyens d'alimentation en gaz de ladite enceinte, et des moyens d'extraction de ladite enceinte des gaz de décomposition de la substance organique enduisant la bande 4 (non représentés).

Dans ce mode de réalisation particulier, des lampes UV 7a, 7b, 7c, 7d, 7e, et 7f sont disposées entre les électrodes haute tension 5a, 5b, 5c, 5d, 5e, 5f et 5g de manière à permettre d'une part une homogénéisation du traitement au niveau de la décharge, et d'autre part de dissocier l'ozone s'étant formé en dehors du volume inter électrodes. De ce fait, la bande 4 peut continuer à être dégraissée en dehors de l'espace inter électrodes par les radicaux O° issus de l'absorption dissociative de l'ozone induit par l'application du rayonnement UV (253 nm) additionnel.

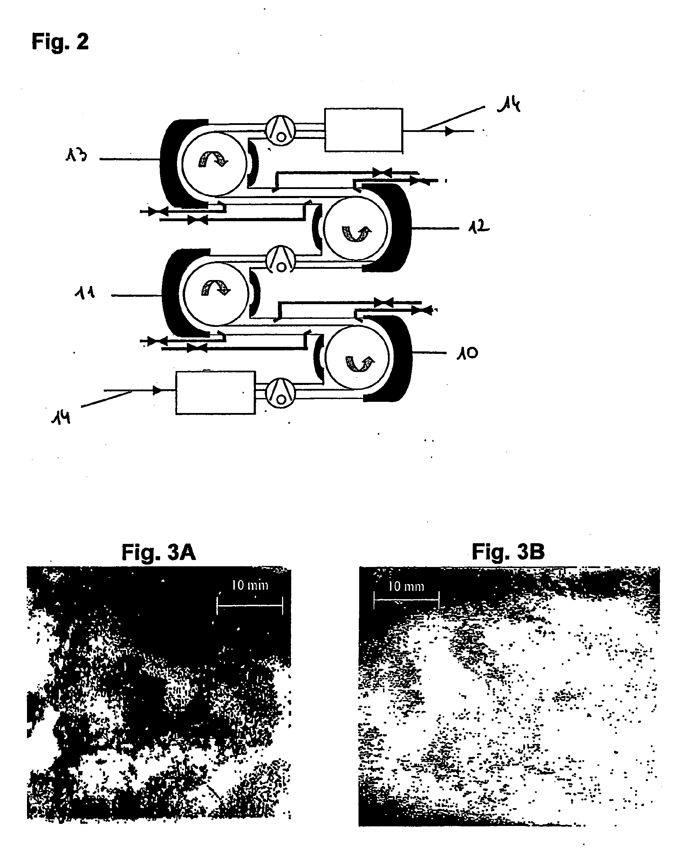

La figure 2 est une représentation schématique d'une installation selon l'invention comprenant une succession de quatre modules 10, 11, 12 et 13, permettant de réaliser un traitement successif des deux faces d'une bande 14 en défilement. Les quatre modules 10, 11, 12 et 13 sont connectés entre eux via des pièces intermédiaires accueillant le groupe de pompage et le système d'introduction des gaz qui assure la mise sous flux de l'installation et donc l'homogénéisation du traitement et ce malgré les caractéristiques de la décharge inhomogène.

### Exemples

Les essais ont été réalisés sur des tôles de petites dimensions (20 à 25 cm²) en statique, recouvertes d'une huile de protection (Quaker Chemical Tinnol 200 ®) qu'il convenait de dégraisser totalement, pour simuler un traitement de nettoyage avant revêtement.

### Appareillage utilisé

Les essais ont été menés dans un réacteur à barrière diélectrique consistant en une électrode recouverte d'une couche de 0,7 mm d'alumine et en une électrode métallique mise à la masse sur laquelle la tôle à traiter est posée. L'électrode recouverte d'alumine est connectée à la haute tension (350 à 4400 V). La haute tension est délivrée par un générateur sinusoïdal de moyennes fréquences (3 à 30 kHz). Les deux électrodes sont équipées d'un système de refroidissement qui leur permet de rester à des températures avoisinant la température ambiante en cours de fonctionnement du plasma.

La distance inter électrodes peut être réglée entre un et plusieurs dizaines de millimètres.

### Exemple 1

On a procédé au traitement de deux tôles en acier au carbone identiques, recouvertes d'une couche de 186 mg/m² d'huile de protection. Les autres paramètres sont quant à eux identiques pour les deux traitements :
- 200 mbar d'oxygène,
- tension sinusoïdale à 12 kHz, de 3 600 V; intensité de 30 mA,
- distance inter-électrodes de 5 mm.
Les traitements des tôles illustrés en figures 3 A et 3 B ne diffèrent que par l'imposition ou non d'un rayonnement UV.

La figure 3 présente une image des surfaces de tôles traitées par une décharge initiée dans l'oxygène seul, en présence (3B) ou non (3A) d'une irradiation UV (253 nm) supplémentaire. Les zones noires correspondent aux endroits non dégraissés sur lesquels l'huile a polymérisé.

On voit que l'application d'un rayonnement UV en plus de la décharge débouche sur une polymérisation moindre de l'huile permettant ainsi un bon nettoyage, en un temps réduit.

L'application d'un rayonnement UV dont la longueur d'onde correspond à l'absorption dissociative de l'ozone engendre la présence homogène de radicaux oxygène à la surface de la tôle qui permettent une combustion froide de l'huile.

L'application d'un rayonnement UV en plus de la décharge débouche non seulement sur une répartition plus homogène des radicaux oxygénés à la surface de la tôle, mais engendre également un accroissement de la densité des radicaux O, tous les paramètres de décharge restant constants (Tension, fréquence d'imposition de la tension, courant, pression, distance inter électrodes).

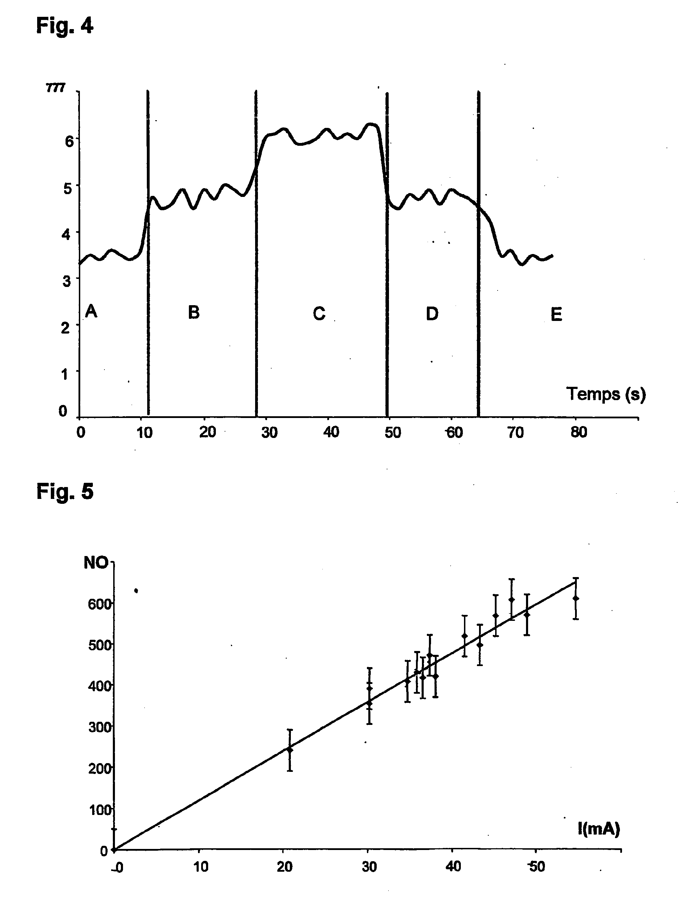

La figure 4 met en évidence l'augmentation de la densité des radicaux oxygène lors de l'application d'un rayonnement UV de 253 nm par le biais de la spectroscopie d'émission optique (OES). La longueur d'onde d'émission des radicaux oxygène excités se situe aux environs de 777 nm. Cette figure représente l'intensité I₇₇₇ du rayonnement à 777 nm en fonction du temps t. Les différentes zones du graphique correspondent aux phases suivantes :
- zone A : aucune décharge électrique, ni rayonnement UV n'est appliqué. L'intensité relevée correspond au bruit de fond.
- zone B : on a appliqué une décharge électrique dans l'oxygène pur, sans appliquer de rayonnement UV.
- zone C : en plus de la décharge électrique, on a appliqué un rayonnement UV à 253 nm,
- zone D : le rayonnement UV est maintenu, en l'absence de décharge électrique.
- zone E : on arrête le rayonnement UV et l'on retrouve le bruit de fond.

### Exemple 2

La figure 5 montre par le biais de la spectroscopie d'émission optique que la densité d'espèces oxygénées actives O° varie linéairement en fonction de l'intensité du courant appliqué dans la décharge.

Les courants de décharges repris sur cette figure ont été variés aussi bien à tension constante en jouant sur la fréquence d'imposition de V, et donc sur l'impédance du diélectrique, qu'à fréquence constante en faisant varier la tension. Cette figure 5 montre donc que la densité d'espèces actives ne dépend que de l'intensité du courant de décharge et n'est en aucun cas influencée par la tension de décharge à courant constant. Cela signifie qu'il est possible d'obtenir une même densité d'espèces actives à des puissances qui ne diffèrent que par la tension imposée, le courant restant constant. Or, on a constaté qu'une tension trop importante débouchait sur une polymérisation de l'huile qui tend à inhiber la cinétique d'oxydation des résidus organiques présents à la surface de la tôle. De plus, une application industrielle requiert la dissipation d'une densité d'énergie minimale dans la décharge (inférieure à 40 W cm⁻² s). Dès lors, la mise au point des conditions de décharge nécessaires au dégraissage d'une tôle passe par une maximisation du courant pour une tension imposée minimale.

L'influence de la puissance de la décharge à courant constant sur la cinétique de dégraissage est mise en évidence dans le tableau ci-dessous qui rassemble deux essais effectués en faisant varier la fréquence du courant sinusoïdal appliqué :

| Puissance de décharge (W) | Tension (V) | Pourcentage de dégraissage | Fréquence (kHz) |
|---|---|---|---|
| 110 | 3400 | 83 % | 10 |
| 55 | 1720 | 87 % | 20 |

On voit donc qu'à courant de décharge égal et pour un temps de traitement identique, l'efficacité du dégraissage est meilleure à plus faible tension et donc à plus faible puissance.

### Exemple 3

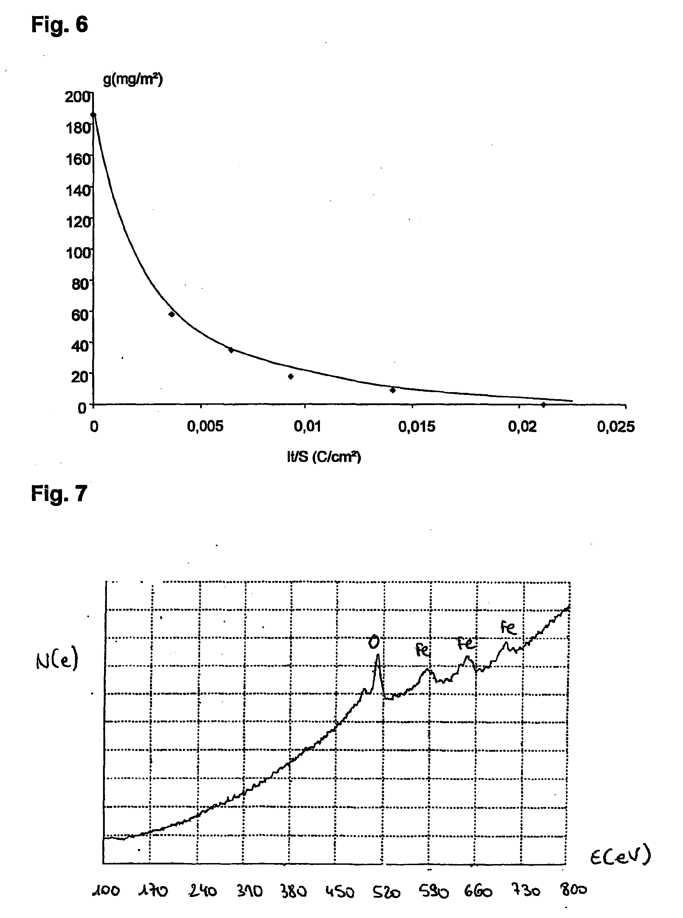

On traite par le procédé selon l'invention, une tôle de 20 cm² couverte de 186 mg/m² d'huile de protection. Dans le cas présent, la décharge est initiée dans l'oxygène sous flux, à une pression de 350 mbar. On ne redissocie pas les molécules d'oxygène et/ou d'ozone formées à partir des radicaux libres O° recombinés. La figure 6 présente l'évolution du grammage en huile de protection présente sur la tôle en fonction de la dose électronique It/S (produit de la densité du courant électronique et du temps de traitement). L'application du flux permet un traitement homogène de la tôle qui a été vérifié par spectroscopie d'absorption infrarouge en incidence rasante (IRRAS).

La figure 7 présente le spectre des électrons Auger de la surface de la tôle dégraissée à l'aide d'une décharge impliquant une dose électronique de
21 mC/cm². Seuls les pics du fer et de l'oxygène sont présents. L'absence de pic de carbone autour de 273 eV confirme le dégraissage total de la tôle.

## Revendications

1. Procédé de nettoyage de la surface d'un matériau enduit d'une substance organique, **caractérisé en ce qu'**il comprend les étapes consistant à :
- introduire ledit matériau dans une enceinte de traitement à l'intérieur de laquelle règne une pression comprise entre 10 mbar et 1 bar, et qui est alimentée par un flux gazeux comprenant au moins 90% en volume d'oxygène,
- générer un plasma en faisant passer une décharge électrique entre la surface dudit matériau et une électrode recouverte de diélectrique, afin de décomposer ladite substance organique sous l'action des radicaux libres O° ainsi produits.

2. Procédé selon la revendication 1, **caractérisé en ce que** l'on re-dissocie les molécules d'oxygène et/ou d'ozone qui se sont formées par recombinaison des radicaux libres O° produits dans ledit plasma.

3. Procédé selon la revendication 1 ou 2, **caractérisé en ce que** ladite re-dissociation est effectuée au moyen d'un rayonnement UV de longueur d'onde adaptée.

4. Procédé selon l'une quelconque des revendications 1 à 3, **caractérisé en ce que** la tension appliquée pour initier la décharge est sinusoïdale, et présente une fréquence comprise entre 10 et 100 kHz.

5. Procédé selon l'une quelconque des revendications 1 à 4, **caractérisé en ce que** la dissipation d'énergie dans la décharge est inférieure à 40 W/cm² et la tension appliquée pour initier la décharge est inférieure à 4 400 V.

6. Procédé selon l'une quelconque des revendications 1 à 5, **caractérisé en ce que** le matériau est sous forme d'une bande en défilement, et **en ce que** les différentes étapes du procédé sont réalisées en continu au moyen d'installations disposées successivement sur le trajet de la bande en défilement.

7. Procédé selon la revendication 6, **caractérisé en ce que** l'on traite successivement une des faces de ladite bande puis l'autre.

8. Procédé selon l'une quelconque des revendications 1 à 7, **caractérisé en ce que** ledit matériau à traiter est un matériau métallique.

9. Procédé selon la revendication 8, **caractérisé en ce que** ledit matériau métallique est un acier au carbone.

10. Procédé selon l'une quelconque des revendications 8 ou 9, **caractérisé en ce qu'**il est mis en oeuvre pour dégraisser la surface de matériaux métalliques, préalablement au dépôt d'un revêtement sur ladite surface.

11. Installation pour la mise en oeuvre du procédé selon l'une quelconque des revendications 6 à 10, comprenant au moins un module comprenant une enceinte de traitement (2), des moyens permettant de régler la pression à l'intérieur de ladite enceinte à une valeur comprise entre 10 mbar et 1 bar, des moyens de défilement (3) dans ladite enceinte de ladite bande (4) reliée à la masse, une série d'électrodes (5a, 5b, 5c, 5d, 5e, 5f, 5g) recouvertes de diélectrique disposées en face de la surface à traiter de ladite bande (4), ces électrodes (5a, 5b, 5c, 5d, 5e, 5f, 5g) étant reliées à un générateur haute tension sinusoïdale (6), des lampes à émission UV (7a,7b,7c,7d,7e,7f) disposées entre lesdites électrodes (5a, 5b, 5c, 5d, 5e, 5f, 5g), des moyens d'alimentation en gaz de ladite enceinte (2), et des moyens d'extraction de ladite enceinte des gaz de décomposition de la substance organique enduisant la bande (4).

12. Installation selon la revendication 11, **caractérisé en ce qu'**elle comprend une succession d'un nombre pair desdits modules (10,11,12,13), à l'intérieur desquels ladite bande (14) défile successivement, exposant tour à tour une de ses faces aux électrodes desdits modules (10,11,12,13).

## Claims

1. Process for cleaning the surface of a material coated with an organic substance, **characterized in that** it comprises the steps consisting in:
- introducing said material into a treatment chamber, having a pressure of between 10 mbar and 1 bar therein, which is supplied with a gas stream containing at least 90% oxygen by volume; and
- generating a plasma by passing an electric discharge between the surface of said material and a dielectric-covered electrode, so as to break down said organic substance through the action of the free radicals O° thus produced.

2. Process according to Claim 1, **characterized in that** the oxygen and/or ozone molecules that are formed by recombination of the free radicals O° produced in said plasma are re-dissociated.

3. Process according to Claim 1 or 2, **characterized in that** said re-dissociation is carried out by means of UV radiation of suitable wavelength.

4. Process according to any one of Claims 1 to 3, **characterized in that** the voltage applied in order to initiate the discharge is sinusoidal and has a frequency of between 10 and 100 kHz.

5. Process according to any one of Claims 1 to 4, **characterized in that** the energy dissipation in the discharge is less than 40 W/cm² and the voltage applied in order to initiate the discharge is less than 4.4 kV.

6. Process according to any one of Claims 1 to 5, **characterized in that** the material is in the form of a running strip and **in that** the various steps of the process are carried out continuously by means of installations placed in succession along the path of the running strip.

7. Process according to Claim 6, **characterized in that** one of the faces of said strip is treated, followed in succession by the other.

8. Process according to one of Claims 1 to 7, **characterized in that** said material to be treated is a metallic material.

9. Process according to Claim 8, **characterized in that** said metallic material is a carbon steel.

10. Process according to either of Claims 8 and 9, **characterized in that** it is carried out in order to degrease the surface of metallic materials, prior to a coating being deposited on said surface.

11. Installation for carrying out the process according to any one of Claims 6 to 10, which comprises at least one module comprising a treatment chamber (2), means for setting the pressure inside said chamber to a value between 10 mbar and 1 bar, means (3) for making said earthed strip (4) run through said chamber, a series of dielectric-covered electrodes (5a, 5b, 5c, 5d, 5e, 5f, 5g) placed so as to face that surface of said strip (4) to be treated, these electrodes (5a, 5b, 5c, 5d, 5e, 5f, 5g) being connected to a sinusoidal high-voltage generator (6), UV emission lamps (7a, 7b, 7c, 7d, 7e, 7f) placed between said electrodes (5a, 5b, 5c, 5d, 5e, 5f, 5g), means for supplying said chamber (2) with gas and means for extracting from said chamber the gases resulting from the decomposition of the organic substance coating the strip (4).

12. Installation according to Claim 11, **characterized in that** it comprises a succession of an even number of said modules (10, 11, 12, 13), through which said strip (14) runs in succession, exposing in turn one of its faces to the electrodes of said modules (10, 11, 12, 13).

## Patentansprüche

1. Verfahren zum Reinigen der Oberfläche eines mit einer organischen Substanz beschichteten Materials, **dadurch gekennzeichnet, dass** es die Schritte aufweist, die darin bestehen:
- das Material in einen Behandlungsbehälter einzuführen, in dessen Inneren ein Druck herrscht, der zwischen 10 mbar und 1 bar beträgt, und der von einem gasförmigen Fluss gespeist wird, der mindestens 90 Vol.-% Sauerstoff enthält,
- ein Plasma zu erzeugen, indem man eine elektrische Entladung zwischen der Oberfläche des Materials und einer mit einem Dielektrikum bedeckten Elektrode stattfinden lässt, um die organische Substanz unter der Einwirkung der so erzeugten freien Radikale O° zu zersetzen.

2. Verfahren nach Anspruch 1, **dadurch gekennzeichnet, dass** man die Sauerstoff- und/oder Ozonmoleküle, die sich durch Rekombination der in dem Plasma erzeugten freien Radikale O° gebildet haben, redissoziiert.

3. Verfahren nach Anspruch 1 oder 2, **dadurch gekennzeichnet, dass** die Redissoziation mit Hilfe einer UV-Strahlung mit einer angepassten Wellenlänge durchgeführt wird.

4. Verfahren nach einem der Ansprüche 1 bis 3, **dadurch gekennzeichnet, dass** die Spannung, die angelegt wird, um die Entladung auszulösen, sinusförmig ist und eine Frequenz aufweist, die zwischen 10 und 100 kHz beträgt.

5. Verfahren nach einem der Ansprüche 1 bis 4, **dadurch gekennzeichnet, dass** die Energiedissipation in der Entladung niedriger als 40 W/cm² ist und die zum Auslösen der Entladung angelegte Spannung niedriger als 4 400 V ist.

6. Verfahren nach einem der Ansprüche 1 bis 5, **dadurch gekennzeichnet, dass** das Material die Form eines durchlaufenden Bandes hat, und **dadurch**, dass die verschiedenen Schritte des Verfahrens kontinuierlich mit Hilfe von Anlagen realisiert werden, die nacheinander auf dem Weg des durchlaufenden Bandes angeordnet sind.

7. Verfahren nach Anspruch 6, **dadurch gekennzeichnet, dass** nacheinander zunächst eine der Seiten des Bandes und danach die andere behandelt wird.

8. Verfahren nach einem der Ansprüche 1 bis 7, **dadurch gekennzeichnet, dass** das zu behandelnde Material ein metallisches Material ist.

9. Verfahren nach Anspruch 8, **dadurch gekennzeichnet, dass** das metallische Material ein Kohlenstoffstahl ist.

10. Verfahren nach einem der Ansprüche 8 oder 9, **dadurch gekennzeichnet, dass** es angewendet wird, um die Oberfläche von metallischen Materialien vor der Aufbringung einer Beschichtung auf die Oberfläche zu entfetten.

11. Anlage zur Durchführung des Verfahrens nach einem der Ansprüche 6 bis 10, welche aufweist: wenigstens ein Modul, das einen Behandlungsbehälter (2) aufweist, Mittel, die es ermöglichen, den Druck im Inneren des Behälters auf einen Wert einzuregeln, der zwischen 10 mbar und 1 bar beträgt, Mittel zum Durchlaufen (3) des mit Masse verbundenen Bandes (4) in dem Behälter, eine Reihe von mit einem Dielektrikum bedeckten Elektroden (5a, 5b, 5c, 5d, 5e, 5f, 5g), die gegenüber der zu behandelnden Oberfläche des Bandes (4) angeordnet sind, wobei diese Elektroden (5a, 5b, 5c, 5d, 5e, 5f, 5g) mit einem Generator einer sinusförmigen Hochspannung (6) verbunden sind, UV-Strahlungslampen (7a, 7b, 7c, 7d, 7e, 7f), die zwischen den Elektroden (5a, 5b, 5c, 5d, 5e, 5f, 5g) angeordnet sind, Mittel zur Speisung des Behälters (2) mit Gas und Mittel zur Extraktion der Zersetzungsgase der organischen Substanz, mit der das Band (4) beschichtet ist, aus dem Behälter.

12. Anlage nach Anspruch 11, **dadurch gekennzeichnet, dass** sie eine Aufeinanderfolge einer geraden Anzahl der Module (10, 11, 12, 13) aufweist, in deren Inneren das Band (14) nacheinander durchläuft, wobei es abwechselnd jeweils eine seiner Seiten den Elektroden der Module (10, 11, 12, 13) exponiert.
